(19) Europäisches Patentamt / European Patent Office / Office européen des brevets

(11) **EP 2 334 848 B1**

(12) **FASCICULE DE BREVET EUROPEEN**

(45) Date de publication et mention de la délivrance du brevet:
**26.12.2012 Bulletin 2012/52**

(21) Numéro de dépôt: **09756003.1**

(22) Date de dépôt: **09.10.2009**

(51) Int Cl.:
$C30B\ 11/12$ (2006.01)   $C30B\ 29/06$ (2006.01)
$C30B\ 29/60$ (2006.01)   $C30B\ 29/08$ (2006.01)
$H01L\ 29/06$ (2006.01)   $H01L\ 29/786$ (2006.01)

(86) Numéro de dépôt international:
**PCT/FR2009/051932**

(87) Numéro de publication internationale:
**WO 2010/040967 (15.04.2010 Gazette 2010/15)**

(54) **PROCEDE DE FABRICATION DE NANOFILS SEMICONDUCTEURS A CROISSANCE LATERALE ET TRANSISTORS OBTENUS PAR CE PROCEDE**

VERFAHREN ZUR HERSTELLUNG VON SEITENWACHSTUMS-HALBLEITERNANODRÄHTEN UND NACH DEM VERFAHREN ERHALTENE TRANSISTOREN

METHOD FOR MAKING SIDE GROWTH SEMICONDUCTOR NANOWIRES AND TRANSISTORS OBTAINED BY SAID METHOD

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **09.10.2008 FR 0856832**

(43) Date de publication de la demande:
**22.06.2011 Bulletin 2011/25**

(73) Titulaires:
• **Ecole Polytechnique**
  **91120 Palaiseau (FR)**
• **Centre National de la Recherche Scientifique**
  **75794 Paris Cedex 16 (FR)**

(72) Inventeurs:
• **ROCA I CABARROCAS, Pere**
  **F-91140 Villebon sur Yvette (FR)**
• **YU, Linwei**
  **F-91120 Palaiseau (FR)**

(74) Mandataire: **Michelet, Alain et al**
  **Cabinet HARLE et PHELIP**
  **14-16, rue Ballu**
  **75009 Paris (FR)**

(56) Documents cités:
• **SCHMIDT V ET AL: "Realization of a silicon nanowire vertical surround-gate field-effect transistor" SMALL JANUARY 2006 WILEY-VCH VERLAG DE, vol. 2, no. 1, janvier 2006 (2006-01), pages 85-88, XP002529835**
• **ALET P-J ET AL: "In situ generation of indium catalysts to grow crystalline silicon nanowires at low temperature on ITO" JOURNAL OF MATERIALS CHEMISTRY 2008 ROYAL SOCIETY OF CHEMISTRY; THOMAS GRAHAM HOUSE; SCIENCE PARK GB vol. 18, no. 43, 7 octobre 2008 (2008-10-07), 7 octobre 2008 (2008-10-07), pages 5187-5189, XP002529836 Extrait de l'Internet: URL:http://www.rsc.org/publishing/journals /JM/ article.asp?doi=b813046a> [extrait le 2008-10-07]**
• **MIN ZOU ET AL: "Silicon nanowires by aluminum-induced crystallization of amorphous silicon" ELECTROCHEMICAL AND SOLID-STATE LETTERS ELECTROCHEM. SOC USA, vol. 9, no. 2, février 2006 (2006-02), pages G31-G33, XP002529837 ISSN: 1099-0062**
• **LIN H-N ET AL: "Selective growth of vertically aligned carbon nanotubes on nickel oxide nanostructures created by atomic force microscope nano-oxidation" CHEMICAL PHYSICS LETTERS, NORTH-HOLLAND, AMSTERDAM, vol. 399, no. 4-6, 1 décembre 2004 (2004-12-01), pages 422-425, XP004646188 ISSN: 0009-2614**

**Description**

La présente invention concerne un procédé de fabrication de nanofils, un procédé de fabrication d'un dispositif électronique à base de nanofils semiconducteurs obtenus par ce procédé ainsi qu'un transistor à base de nanofils semiconducteurs également obtenus par ce procédé.

Plus particulièrement, l'invention concerne un procédé de fabrication de nanofils de silicium par plasma (PECVD plasma enhanced chemical vapor deposition) et recuit thermique, c'est-à-dire un procédé « sec », contrairement aux procédés en phase liquide. Le procédé de l'invention permet de fabriquer des nanofils dont on peut contrôler les propriétés morphologiques telles que la forme (droite ou enroulée), la taille et/ou la longueur.

L'invention porte également sur l'utilisation de ces nanofils de silicium dans des applications à micro et la nanoélectronique, par exemple pour la réalisation de transistors et la connectique.

Depuis quelques années on sait fabriquer des structures ordonnées de très petites tailles telles que les nanotubes de carbone, les nanofils et les nanobâtonnets de silicium.

Par exemple le document FR2860780 (D. Pribat et al.) décrit un procédé de fabrication de nanofils de carbone à partir d'une matrice nanoporeuse dans laquelle on dépose un catalyseur métallique. Les nanofils de carbone croissent par épitaxie perpendiculairement à la surface du substrat cristallin.

Le document FR2888041 (D. Pribat et al.) décrit également la fabrication de nanofils ou de nanobâtonnets de silicium à partir d'un procédé VLS (vapeur-liquide-solide). Selon ce procédé, on grave des pores creux dans un substrat d'aluminium, on dépose au fond des pores un catalyseur métallique, puis on fait croître des nanofils de silicium, qui peuvent être dopés sélectivement en cours de croissance de manière à générer des fils conducteurs ou des jonctions électroniques de type NIN ou PIP. Là encore, la croissance des nanofils est généralement perpendiculaire à la surface du substrat. Des solutions pour utiliser ces nanofils consistent à faire croître les nanofils transversalement à une surface, puis à les transférer vers un autre substrat pour les positionner par exemple entre deux contacts électriques formés sur la surface de l'échantillon.

Les nanotubes et nanofils présentent des caractéristiques électriques particulièrement intéressantes, leur conductivité pouvant se situer plusieurs ordres de grandeur au dessus de celle de structures de taille micronique ou submicronique.

Les nanofils obtenus suivant les techniques décrites dans ces documents antérieurs croissent perpendiculairement à la surface sur laquelle est déposé le catalyseur. Pour obtenir des fils parallèles à la surface du substrat il faut donc former des pores parallèles à cette surface et déposer le catalyseur au fond des pores (cf. FR2888041).

Les procédés VLS sont toutefois compliqués car ils nécessitent plusieurs étapes et plusieurs techniques différentes. Un procédé se déroule généralement selon les étapes suivantes : 1) nettoyage du substrat, 2) dépôt du catalyseur par exemple par évaporation, 3) recuit dans un four de la couche évaporée pour former des gouttelettes, 4) transfert du substrat avec catalyseurs vers une enceinte de CVD, 5) croissance des nanofils par exposition du catalyseur à un gaz, du silane par exemple, à une température supérieure à celle de fusion des gouttes de catalyseur. Certaines étapes nécessitent de hautes températures (T > 600°C). De plus, toutes ces opérations et les transferts de l'échantillon entre chaque étape doivent se faire en salle blanche afin d'éviter les contaminations par des poussières de taille micro-ou nanométrique. De plus, le catalyseur est au moins partiellement oxydé lors de son exposition à l'air.

Ces procédés VLS sont généralement longs et coûteux et peuvent poser des problèmes de reproductibilité étant donné le grand nombre d'étapes et de techniques impliquées. De plus, ces procédés conduisent à une croissance verticale (transverse à la surface du substrat) qui est peu propice à leur utilisation pour former des liaisons électriques. Le seul exemple de croissance horizontale de nanofils est décrit dans les brevets de D. Pribat basés sur l'utilisation de matrices poreuses spécifiques de $Al_2O_3$.

Par ailleurs, on connaît les procédés de dépôt et de gravure de couches minces par dépôt chimique en phase vapeur assisté par plasma (PECVD pour Plasma Enhanced Chemical Vapor Deposition) pour la fabrication de composants microélectroniques, d'écrans plats et cellules solaires.

P.J. Alet et al, dans J. of Mater. Chem, 2008, 18, 5187-5189 décrit un procédé de croissance de nanofils Silicium sur couche d'ITO par plasma hydrogène puis plasma CVD, les nanofils obtenus sur les nanogouttes d'Indium étant verticaux.

V. Schmidt et al, dans Small 2006, 2, (1) 85-88 décrit des transistors utilisant un nanofil Silicium vertical.

Les procédés plasma ont l'avantage d'être réalisés en enceinte à vide contrôlée en température et en pression, sont rapides et permettent d'obtenir une très bonne uniformité sur de très grandes surfaces. Il est également possible de contrôler la structure cristallographique des couches déposées en fonction des conditions de la composition des gaz du plasma, de la pression et de la température... On sait ainsi déposer des couches de silicium dans l'état amorphe, polycristallin, microcristallin, ou nanocristallin... Ces couches peuvent ensuite être gravées sélectivement suivant les procédés connus de masquage et insolation par photolithographie pour fabriquer des structures sub-micrométrique. Toutefois, la photolithographie est limitée par la limite optique de la diffraction, et il est difficile de fabriquer des structures de dimension nanométrique par ces techniques.

L'invention a pour but de remédier à ces inconvénients et concerne plus particulièrement un procédé de fabrication de nanofils semiconducteurs sur un substrat comprenant une couche d'oxyde métallique. Selon l'invention, le procédé comprend les étapes suivantes :

- (a) exposition de la couche d'oxyde métallique à un plasma d'hydrogène de puissance P pendant une durée t apte à produire une réduction de la couche d'oxyde métallique et à former des nanogouttes métalliques de rayon ($R_m$) en surface de la couche d'oxyde métallique ;
- (b) dépôt assisté par plasma basse température d'une couche mince d'un matériau semiconducteur sur la couche d'oxyde métallique comprenant les nanogouttes métalliques, ladite couche ayant une épaisseur ($H_a$) apte à recouvrir les nanogouttes métalliques ;
- (c) recuit thermique sous vide à une température T supérieure ou égale à la température de fusion des nanogouttes métalliques (3) afin d'activer une croissance latérale de nanofils semiconducteurs par catalyse du matériau semiconducteur déposé en couche mince à partir des nanogouttes métalliques.

Selon un mode de réalisation de l'invention, le matériau semiconducteur déposé en couche mince est choisi parmi du Silicium (Si), du Germanium (Ge), du Carbone (C), ou un alliage de ces matériaux (SiGe, SiC, ou SiGeC), ledit matériau semiconducteur étant déposé sous forme amorphe, micro- ou poly-cristalline.

Selon un mode de réalisation préféré, l'invention concerne un procédé de fabrication de nanofils de silicium et le matériau de la couche déposée est du silicium amorphe hydrogéné (a-Si :H) d'épaisseur ($H_a$).

Selon un autre mode de réalisation de l'invention, l'invention concerne un procédé de fabrication de nanofils de carbone et le matériau de la couche déposée est du carbone amorphe hydrogéné (a-C :H) d'épaisseur ($H_a$).

Selon un mode de réalisation préféré du procédé de fabrication de nanofils de l'invention, l'oxyde métallique est un oxyde d'indium (InO), d'étain ($SnO_2$), de zinc (ZnO) ou un alliage ITO (Indium Tin Oxide), ou un système multicouche ZnO/ITO ou ZnO /$SnO_2$.

Selon un mode de réalisation particulier de l'invention, le rayon ($R_m$) des nanogouttes métalliques étant connu, la durée de dépôt de la couche semiconductrice est fixée de manière à obtenir un rapport η prédéterminé entre l'épaisseur ($H_a$) de la couche déposée et le rayon ($R_m$), ce rapport η étant apte à assurer la croissance latérale des nanofils.

Selon un mode de réalisation préféré de l'invention, le rapport η est ajusté pour être égal à 1 de manière à ce que la morphologie des nanofils soit rectiligne sur une longueur comprise entre 10 fois le diamètre du nanofil à plus de 100 fois le diamètre du nanofil.

Selon un mode de réalisation préféré, le procédé de fabrication de nanofils de l'invention comprend en outre une étape de masquage local de la couche d'oxyde métallique de manière à former des électrodes et la croissance d'un nanofil est réalisée entre deux électrodes.

Selon un mode de réalisation particulier de l'invention, le procédé de fabrication de nanofils comprend une étape de formation d'un moyen de guidage, lors de l'étape (c) de recuit thermique, la croissance latérale des nanofils semiconducteurs étant guidée le long dudit moyen de guidage, selon un chemin prédéfini.

Selon un mode de réalisation préféré, l'étape de formation d'un moyen de guidage consiste à former un canal de matériau semiconducteur, ledit canal formant ledit moyen de guidage.

Selon un mode de réalisation préféré, le diamètre du canal de matériau semiconducteur est sensiblement égal à celui de la nanogoutte métallique.

Selon un mode de réalisation préféré, l'étape de formation d'un moyen de guidage consiste à former une marche sur le substrat, ladite marche comprenant une paroi latérale, et formant ledit moyen de guidage.

Selon un mode de réalisation préféré, le procédé de fabrication de nanofils comprend, entre l'étape (a) et l'étape (b) une étape de dépôt d'une couche de matériau diélectrique, suivie d'une étape de gravure de ladite couche de matériau diélectrique pour former ladite marche dans ladite couche de matériau diélectrique.

Selon un mode de réalisation préféré, le procédé de fabrication de nanofils comprend, entre l'étape (b) et l'étape (c), une opération (b') de formation de bordures sur la couche mince de matériau semiconducteur, ladite opération (b') étant réalisée par gravure ionique, et chaque bordure sétendant sur la couche mince de matériau semiconducteur de façon à former ledit moyen de guidage.

Le procédé de l'invention permet de contrôler la direction et la forme des nanofils et de faire croître les nanofils directement sur le substrat, d'une électrode à une autre, par exemple. Il est possible d'obtenir toute forme de nanofil désirée dont des nanofils parfaitement rectilignes.

L'invention permet de faire croître des nanofils semiconducteurs non seulement sur une surface plane, mais également sur la surface de n'importe quel objet à 3 dimensions, rendant la conception et la fabrication de réseaux fonctionnels de nanofils de silicium cristallin à 3 dimensions possible. Ceci permet des applications dans les circuits intégrés 3D et les systèmes nano-électro-mécaniques.

L'invention concerne également un procédé de fabrication d'un dispositif électronique comprenant un substrat.

Selon l'invention, le procédé comprend les étapes suivantes :

- (d) former une couche d'oxyde métallique sur ledit substrat, de façon à définir une région d'initiation de la croissance de nanofils semiconducteurs,
- (e) former un ou plusieurs moyens de guidage pour la croissance de nanofils semiconducteurs, chaque moyen de guidage reliant la région d'initiation de la croissance de nanofils semiconducteurs à une région de fin de croissance des nanofils semiconducteurs de façon à définir un chemin fonctionnel,
- (f) fabriquer un ou plusieurs nanofils semiconducteurs selon les étapes (a), (b) et (c) de façon à réaliser une croissance guidée des nanofils semiconducteurs le long des moyens de guidage respectifs, lors de l'étape (c), chaque nanofil semiconducteur initiant sa croissance au niveau de la région d'initiation de la croissance de nanofils semiconducteurs, et la continuant jusqu'à la région de fin de croissance des nanofils semiconducteurs.

Selon un mode de réalisation particulier, lors de l'étape (e), une étape de dépôt d'une couche de matériau diélectrique sur le substrat et la couche d'oxyde métallique est réalisée entre les étapes (a) et (b), cette étape de dépôt d'une couche de matériau diélectrique étant suivie d'une étape de gravure de ladite couche de matériau diélectrique pour former une marche dans ladite couche de matériau diélectrique, ladite marche formant le moyen de guidage pour la croissance de nanofils semiconducteurs.

L'invention concerne également un transistor électrique à base d'un ou plusieurs nanofils semiconducteurs obtenus par le procédé de l'invention, un des nanofils étant apte à former une liaison semiconductrice entre une source, un drain et une grille dudit transistor, la commande étant effectuée à travers la grille séparée du nanofil par une couche diélectrique.

Selon un mode de réalisation particulier, le transistor comprend un réseau de nanofils tridimensionnel.

Avantageusement, le plasma de réduction et le plasma de dépôt sont des plasmas basse température de type radiofréquence.

La présente invention concerne également les caractéristiques qui ressortiront au cours de la description qui va suivre et qui devront être considérées isolément ou selon toutes leurs combinaisons techniquement possibles.

Cette description est donnée à titre d'exemple non limitatif et fera mieux comprendre comment l'invention peut être réalisée en référence aux dessins annexés sur lesquels :

- la figure 1 représente une première étape (a) du procédé de fabrication de nanofils de l'invention ;
- la figure 2 représente une seconde étape (b) du procédé de fabrication de nanofils de l'invention ;
- la figure 3 représente une troisième étape (c) du procédé de fabrication de nanofils de l'invention ;
- la figure 4 est une photographie obtenue au microscope électronique à balayage (MEB) de nanofils obtenus suivant un mode de réalisation de l'invention ;
- la figure 5 est une photographie obtenue au microscope électronique à balayage (MEB) de nanofils quasi rectilignes obtenus suivant un autre mode de réalisation de l'invention ;
- les figures 6a-6c représentent des clichés MEB de nanofils de morphologies et de diamètres différents obtenus suivant différents mode de réalisation du procédé de l'invention ;
- la figure 7 est une photographie par MEB d'une structure électronique comprenant un nanofil de silicium entre deux pistes conductrices ;
- la figure 8 représente une courbe de courant-tension pour une liaison électronique comprenant une couche de silicium amorphe entre deux électrodes ITO ;
- la figure 9 représente une courbe de courant-tension pour une liaison électronique comprenant un nanofil entre deux électrodes ITO, et en insert la conductance de cette liaison ;
- la figure 10 représente un photographie par MEB d'un transistor nanométrique en couche mince, comprenant une liaison semiconductrice à base d'un nanofil, entre le drain et la source du transistor (représenté à droite schématiquement en vue de dessus);
- la figure 11 représente schématiquement une vue en coupe d'un nanofil formant une liaison semiconductrice dans un transistor, le nanofil semiconducteur étant entouré d'une couche de SiNx et d'une couche d'aluminium formant la grille du transistor ;
- la figure 12 représente des courbes courant-tension d'un transistor à base de nanofil semiconducteur, pour différentes tensions drain-source ;
- la figure 13 représente une photographie par MEB d'un nanofil obtenu par une première méthode de croissance latérale guidée ;
- la figure 14 représente schématiquement le principe de cette première méthode de croissance latérale guidée ;
- la figure 15 représente deux photographies par MEB de nanofils obtenus par une deuxième méthode de croissance latérale guidée ;
- la figure 16 représente schématiquement le principe de cette deuxième méthode de croissance latérale guidée ;
- la figure 17 représente une photographie par MEB de nanofils obtenus par une troisième méthode de croissance latérale guidée ;

- la figure 18 représente schématiquement le principe de cette troisième méthode de croissance latérale guidée ;
- la figure 19 représente schématiquement un transistor TFT/FET obtenu avec la deuxième méthode de croissance latérale guidée de l'invention ;
- les figures 20a et 20b représentent chacune une photographie par MEB de nanofils d'un dispositif électronique.

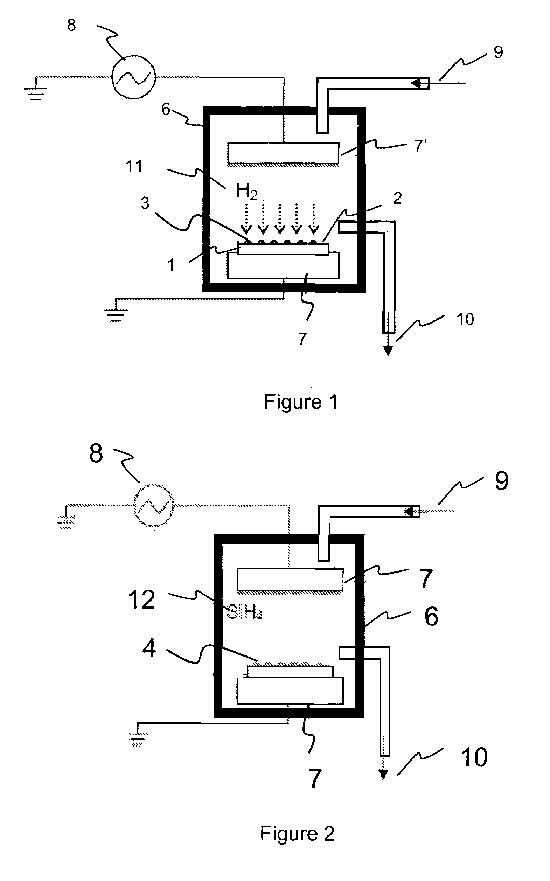

La figure 1 représente schématiquement un réacteur de PECVD dans lequel sont réalisées les différentes étapes d'élaboration de nanofils semiconducteurs suivant l'invention.

Le réacteur comprend une enceinte à vide 6, un porte échantillon 7 électriquement relié à une masse, un générateur RF 8 relié à une électrode RF 7' par l'intermédiaire d'un circuit d'accord d'impédance (non représenté sur la figure). L'enceinte à vide 6 est reliée à des moyens de pompage 10 pour faire le vide dans l'enceinte et à des moyens d'injection de gaz 9 pour former un plasma.

Le substrat 1 comprend une couche mince 2 d'oxyde conducteur (ou d'oxyde métallique) déposée sur une plaque support. Dans les applications photovoltaïques la couche mince 2 est de préférence un oxyde transparent conducteur (TCO). Dans ce cas, l'oxyde transparent conducteur est préférentiellement un oxyde d'indium ($In_2O_3$), d'étain ($SnO_2$), une combinaison d'oxyde de d'indium et d'étain (ITO pour Indium Tin Oxide), un oxyde de zinc (ZnO) ou encore une combinaison de ces différents oxydes métalliques. Le support est par exemple une plaque de verre, ou de silicium cristallin, apte à supporter les températures de l'étape de recuit thermique. Dans un exemple de réalisation, l'épaisseur de la couche 2 d'oxyde métallique ($SnO_2$) est de l'ordre de 100 nm. Le substrat 1 est placé sur le porte échantillon 7 d'un réacteur de dépôt par plasma de type radio-fréquence (à 13,56 MHz). Le porte échantillon 7 constitue l'une des électrodes de la chambre à plasma 6. Une électrode RF 7' est située au dessus du porte échantillon 7. Après avoir effectué le vide dans la chambre à plasma 6, on introduit de l'hydrogène gazeux ($H_2$) pour former un plasma d'hydrogène 11. Le plasma d'hydrogène 11 induit une réduction du TCO, qui forme des gouttelettes métalliques 3 à la surface de la couche d'oxyde métallique.

Le rayon ($R_m$) des gouttelettes de métal 3 obtenues par réduction de la surface de la couche de TCO 2 dépend de la densité ou de la puissance du plasma 11, de la durée d'exposition et de la température. Ce rayon $R_m$ peut être étalonné en fonction des différents paramètres du réacteur et notamment en fonction de la durée du plasma de réduction.

Dans un exemple de réalisation, on effectue un traitement par plasma d'hydrogène ($H_2$) sur un substrat 1 comprenant une couche 2 d'ITO. On obtient ainsi des gouttelettes d'Indium 3 à la surface de la couche d'ITO. Les conditions expérimentales sont par exemple les suivantes : pression en hydrogène ($H_2$) 1000 mTorr, puissance du plasma 2 W ($\sim$25mW/cm$^2$), température du substrat $T_{sub}$=300°C, température de l'électrode RF $T_{RF}$ = 200°C, et durée d'exposition au traitement 1 minute.

Les gouttelettes d'Indium métallique 3 ainsi obtenues ont un diamètre d'environ 30 nm en surface de la couche d'ITO.

La figure 2 correspond à la seconde étape (b) du procédé d'élaboration de nanofils.

Le substrat 1 sur lequel sont formées des gouttelettes de métal 3 catalyseur est maintenu sous vide dans la chambre à plasma 6. Le catalyseur n'est ainsi pas exposé à l'air. On introduit ensuite un nouveau gaz porteur : du silane ($SiH_4$). On applique ensuite un plasma de silane 12, qui permet de déposer une couche mince 4 de silicium amorphe hydrogéné (a-Si :H) sur le substrat ayant subi une réduction, c'est-à-dire pardessus la couche 2 d'oxyde métallique et les gouttelettes métalliques 3. Le plasma de silane 12 est interrompu lorsque l'épaisseur $H_a$ de la couche 4 déposée est suffisante pour recouvrir les gouttelettes métalliques 3. La vitesse de dépôt de la couche de matériau peut être étalonnée pour un réacteur de manière à pouvoir contrôler l'épaisseur $H_a$ en fonction de la durée du dépôt. Dans l'exemple de réalisation, l'épaisseur de la couche 4 de silicium amorphe est comprise entre 0,05 $\mu$m et 1$\mu$m. Les conditions expérimentales sont par exemple les suivantes : pression en silane ($SiH_4$) 120mTorr, puissance du plasma 2 W ($\sim$60mW/cm$^2$), température du substrat $T_{sub}$=100°C, température de l'électrode RF $T_{RF}$=100°C et durée du dépôt 5 minutes.

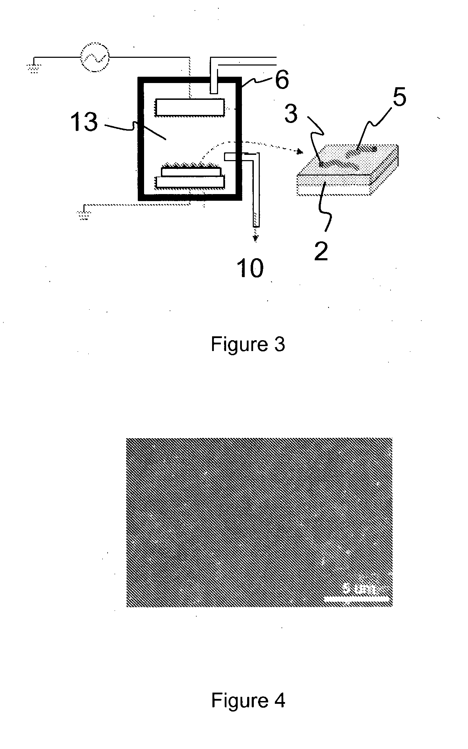

La figure 3 correspond à la troisième étape (c) du procédé d'élaboration de nanofils.

La troisième étape est une étape de recuit thermique sous vide.

Le substrat comprenant les gouttelettes de métal 3 catalyseur recouvertes d'une couche 4 de a-Si :H est maintenu sous vide dans le réacteur 6. L'échantillon est ensuite recuit sous vide (pression résiduelle $\sim$10$^{-6}$mbarr), la température du substrat étant maintenue à $T_{sub}$=500°C et la température de l'électrode RF à $T_{RF}$=400°C pendant une durée de 2 heures pour permettre la croissance latérale des nanofils 5 de silicium (SiNW). La croissance latérale des nanofils 5 de silicium sur la surface du substrat se produit au cours de cette étape.

La température de recuit thermique est supérieure ou égale à la température de fusion des nanogouttes métalliques. La température minimum dépend d'une part du matériau métallique utilisé et de sa température de fusion, mais cette température de fusion peut aussi dépendre de la taille des gouttelettes métalliques. La température minimum dépend également de la solubilité du matériau semiconducteur dans le catalyseur.

En pratique, la température de recuit peut être inférieure 300 °C voire inférieure à 250 °C dans le cas de l'indium. La température peut même être encore plus basse pour d'autres matériaux (Gallium par exemple).

Les gouttelettes de métal catalyseur 3 consomment le silicium amorphe 4 présent en surface, le silicium est ainsi dissous par le catalyseur puis précipite sous forme cristalline, formant ainsi des nanofils 5 de silicium.

La figure 4 montre une photographie MEB de nanofils 5 obtenus selon les étapes du procédé indiqué ci-dessus. On observe des nanofils 5 de diamètre de l'ordre de 50 nanomètres, et dont certains ont une longueur de plusieurs dizaines de microns.

Toutefois la distribution de ces nanofils sur la surface est irrégulière, et les nanofils 5 présentent de nombreuses courbures sur des longueurs de plus de 5 $\mu$m.

Or, il est apparu que la morphologie et la courbure des nanofils de silicium 5 (SiNW pour Silicon Nano Wires) peuvent être ajustées en contrôlant le rapport entre d'une part l'épaisseur ($H_a$) de couverture de la couche de silicium amorphe hydrogéné 4 et d'autre part le rayon ($R_m$) des gouttelettes métalliques 3.

Selon un mode de réalisation préféré de l'invention, un équilibre est obtenu lorsque la condition suivante est remplie :

$$2. \ R_m . H_a. \ \alpha. \ v_{ma} = S_{SiNW} . \ v_{cm}$$

où $V_{cm}$ et $v_{ma}$ sont les vitesses de déplacement respectivement de l'interface cristal-métal et de l'interface métal-amorphe,

$S_{SiNW}$ représente la surface de la section efficace des SiNW 5

$R_m$ le rayon des gouttelettes métalliques (d'indium par exemple)

$H_a$ part l'épaisseur de couverture de la couche 4 de a-Si :H,

Et $a$ la contraction volumique pendant la transformation de silicium de la phase amorphe en phase cristalline.

On suppose que le diamètre d'un nanofil SiNW 5 est proportionnel à celui d'une goutte d'indium 3 :

$$S_{SiNW} = f. \ S_m = f.\pi. \ R^2_m$$

où f est un facteur géométrique.

On obtient ainsi une relation simplifiée entre les vitesses de déplacement des deux interfaces :

$$\eta = v_{cm} / \ v_{ma} \approx A. \ H_a / R_m$$

Avec

$$A = 2 \ . \ \alpha / \pi.f$$

Le rapport entre l'épaisseur de couverture ($H_a$) de la couche de a-Si :H et le rayon ($R_m$) des nanogouttes métalliques 3 est un paramètre clé pour contrôler l'équilibre de la croissance des nanofils de silicium 5, ce qui influence la forme, la courbure et la rugosité de surface des nanofils de silicium 5.

En condition d'équilibre, $\eta \approx 1$, la vitesse de déplacement des deux interfaces se fait au même rythme ($v_{cm} \approx V_{ma}$), et un nanofil 5 de silicium rectiligne peut être obtenu.

Au contraire, hors équilibre, $\eta \neq 1$ induit une déformation des gouttes métalliques 3 et donc une courbure du nanofil SiNW 5.

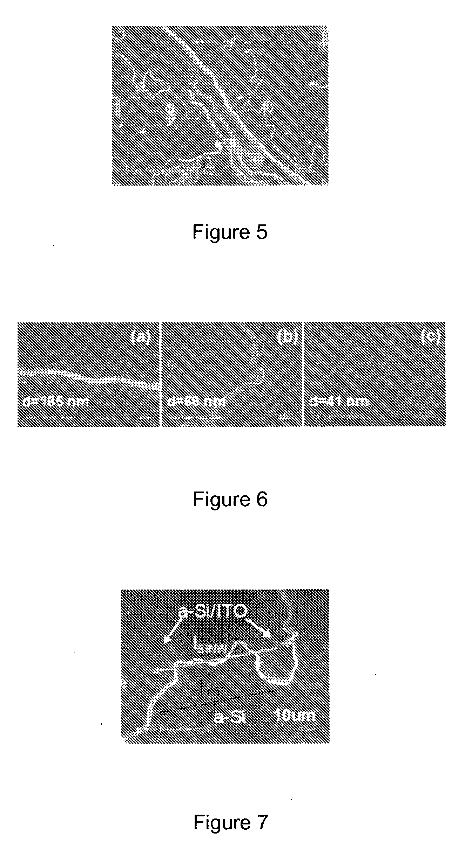

Dans les exemples des figures 5 et 6, des nanofils 5 de silicium SiNW de diamètres différents et de morphologie différentes sont obtenus dans les mêmes conditions de dépôt.

Sur la figure 6a, on mesure au microscope électronique un nanofil 5a de 185 nanomètres de diamètre, qui est quasiment rectiligne sur la longueur du cliché soit environ 4 microns. Sur la figure 6b, on mesure au microscope un nanofil 5b de 68 nanomètres de diamètre avec plusieurs courbures, dont les sections droites ont une longueur inférieure à 1 micron. Sur la figure 6c, on mesure au microscope un nanofil 5c de 41 nanomètres de diamètre, avec de nombreuses courbures.

Puisque $R_m$ ~ f.d , la condition d'équilibre et donc la morphologie de courbure pour les figures 6a à 6c sont différentes. L'épaisseur ($H_a$) de la couche de a-Si :H étant constante, seuls les nanofils 5 ayant un diamètre apparié peuvent se développer de manière équilibrée suivant une ligne droite, comme celui de la figure 6a, où la condition $\eta \approx$ 1 semble remplie. Par contre, les nanofils de diamètres plus petit apparaissent courbés sur la figure 5.

Les conditions expérimentales pour obtenir les nanofils 5 des figures 5-6 sur un échantillon ITO (indium tin oxide) plat sont les suivantes :

|  | étape 1 | étape 2 | étape 3 |
|---|---|---|---|
| Puissance RF | 5W | 2W | 0 |
| Durée | 1 min. | 5 min. | 50 min. |
| Pression | 600 mTorr | 120 mTorr | Vide |
| Débit Gas | 100 sccm $H_2$ | 10 sccm $SiH_4$ | 0 |
| Température électrode RF | 200°C | 100°C | 200°C |
| Température substrat | 300°C | 100°C | 500°C |

Les nanofils de silicium 5 croissent à partir de sites en surface de la couche d'ITO comprenant des gouttes d'indium formées après la première étape de traitement par plasma d'hydrogène. Ensuite, les nanofils croissent latéralement en consommant la matrice de la couche de a-Si :H.

Il est ainsi possible que des nanofils 5 se forment de part et d'autre d'un gap formé entre deux électrodes d'ITO prédéfinies et connectent ainsi les électrodes de manière à former une liaison électrique. On peut ensuite réaliser des réseaux électriques de SiNW assemblés.

La figure 7 montre un exemple de nanofil de silicium 5 formant une liaison entre deux électrodes 14 et 15 d'ITO espacées de 10 microns. Les deux zones latérales claires sont les électrodes ITO recouvertes de a-Si :H et la zone centrale foncée comprend uniquement une couche de a-Si :H. Un seul nanofil SiNW traverse le gap et relie électriquement les deux électrodes d'ITO.

En appliquant un champ électrique entre les électrodes d'ITO deux composantes de courant traversent la liaison : le courant qui circule par le nanofil et le courant qui passe par la couche de a-Si :H qui recouvre toute la structure.

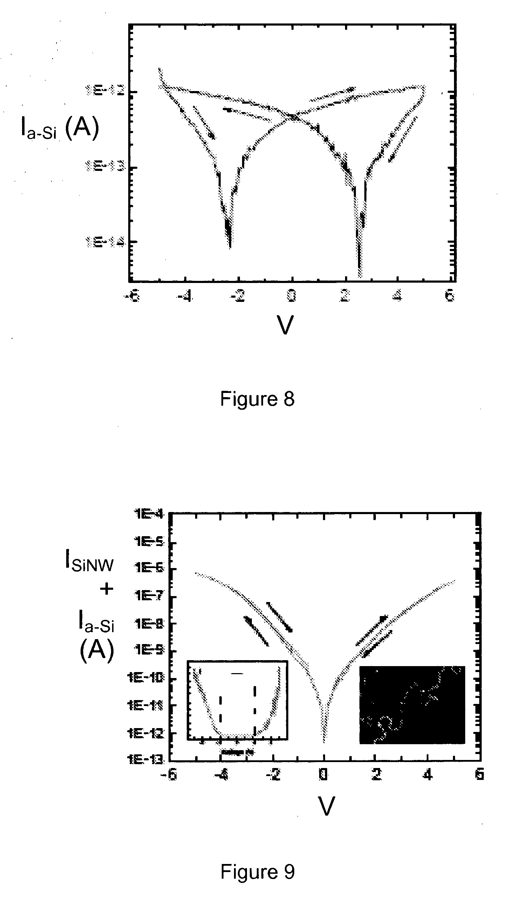

Les figures 8 et 9 montrent les caractéristiques de courant-tension obtenues avec deux paires d'électrodes d'ITO respectivement sans nanofil (Fig. 8) et avec un nanofil (Fig. 9). Le balayage en tension est indiqué par les flèches. L'image du nanofil de la liaison associée à la courbe est également insérée sur la figure 9, ainsi que la mesure de conductivité.

On observe que la densité de courant $I_{SiNW}$ est supérieure à la densité de courant de la couche de silicium amorphe hydrogéné ($I_{a-si}$) d'environ six ordres de grandeur. Les caractéristiques de transport entre de la liaison d'électrodes ITO par un nanofil sont largement dominées par le nanofil SiNW cristallin beaucoup plus conducteur que la couche de silicium amorphe.

Ce résultat incite fortement à développer différentes applications de tels nanofils.

En formant sur le substrat un motif prédéfini de contacts électriques et/ou électroniques, il est ainsi possible de réaliser des composants nanoélectroniques à base de nanofils de silicium (SiNW).

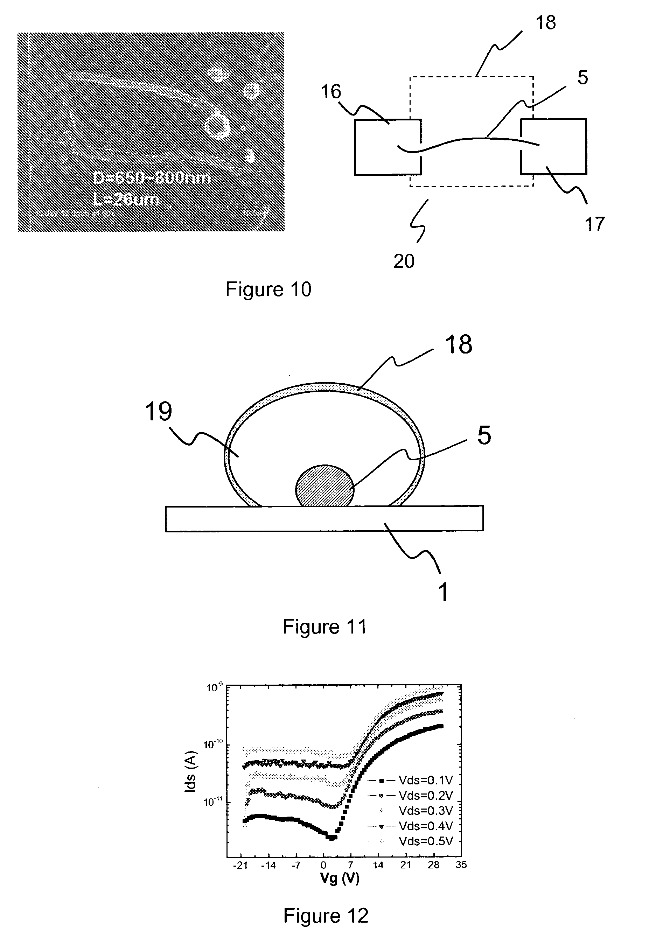

La figure 10 représente un exemple d'application à la fabrication d'un transistor électronique nanométrique dont la liaison semiconductrice est formée par un nanofil obtenu selon le procédé de l'invention, le nanofil joignant à l'une de ses extrémités la source 16 du transistor et l'autre extrémité du nanofil joignant le drain 17 du transistor. Sur la photographie MEB de la figure 10 on observe deux nanofils, dont un seul (celui du bas de la photo) constitue une jonction active entre la source (à gauche de la photo) et le drain (à droite de la photo). Le nanofil du haut de la photo n'est pas actif.

La figure 11 représente une vue en coupe du transistor 20 de la figure 10, suivant une section transverse au nanofil 5. Le nanofil 5 de silicium a un diamètre de 80 nm. Ce nanofil 5 est recouvert d'une première couche de SiNx de 300 nm d'épaisseur, puis d'une couche d'Aluminium de 200 nm. d'épaisseur. En appliquant une tension au niveau de la couche d'Aluminium on active le fonctionnement du transistor 20. La couche d'aluminium constitue ainsi la grille du transistor.

La figure 12 illustre les courbes courant-tension d'un tel transistor, pour différentes tensions $V_{ds}$ appliquées entre la source et le drain du transistor et pour différentes tensions de grille. On observe des courbes de courant-tension caractéristiques d'un transistor électronique.

Le procédé de l'invention permet de guider la croissance de nanofils : cette croissance s'effectue horizontalement dans le plan du substrat et non perpendiculairement à la surface du substrat, comme dans les procédés de type VLS.

Le contrôle des étapes de réduction de l'oxyde métallique pour former des nanogouttes métalliques en surface du substrat et de dépôt d'une couche de matériau amorphe permet d'ajuster les paramètres de manière à obtenir après recuit thermique des nanofils dont le diamètre est de quelques dizaines de nanomètres et qui ont une morphologie rectiligne sur plusieurs microns de longueur.

La nature cristalline des nanofils leur confère de remarquables propriétés. Les nanofils cristallins sont avantageusement conducteurs ou semiconducteurs En particulier, les nanofils de silicium ont des propriétés de conductivité électrique améliorées de plusieurs ordres de grandeur par comparaison avec les couches de silicium amorphe dont ils sont formés. Les nanofils peuvent être dopés, ce qui permet de fabriquer des jonctions PN, NP, PIN... à la base de transistors électroniques.

La fabrication contrôlée et orientée de nanofils semiconducteurs entre deux électrodes permet de fabriquer des composants nanoélectroniques. Les figures 10 à 12 démontrent la fabrication d'un transistor utilisant un tel nanofil comme liaison semiconductrice.

Les trois étapes (formation de gouttelettes métalliques, dépôt du matériau semiconducteur et recuit thermique) du procédé de fabrication de nanofils semiconducteurs peuvent être réalisées dans un même réacteur de dépôt sous vide.

Le procédé de l'invention utilise des procédés de dépôt/gravure plasma RF à basse température suivis d'une étape de recuit thermique dans un même réacteur. Le procédé permet de fabriquer des nanofils à une échelle de taille bien inférieure au micron, le diamètre des nanofils étant de quelques dizaines de nanomètres. Le procédé de l'invention ne requiert pas de photolithographie submicronique ni d'alignement nanométrique et est industrialisable à grande échelle et sur des substrats de très grande taille.

Le procédé de l'invention est un procédé à relativement basse température. La gamme de température se situe entre 250°C et 600°C. L'intérêt est de travailler dans la partie basse température de cette gamme.

Ces basses températures sont compatibles avec des substrats de verre, qui sont largement utilisés par exemple dans des applications telles que les écrans plats et le photovoltaïque.

Selon un mode de réalisation de l'invention, le procédé de fabrication de nanofils comprend une étape de croissance latérale guidée ou contrôlée des nanofils semiconducteurs 5 selon un chemin prédéfini, permettant de contrôler la forme des nanofils et de faire croître les nanofils directement sur le substrat, d'une électrode à une autre, par exemple.

Cette étape de croissance latérale guidée des nanofils semiconducteurs 5 est réalisée lors de l'étape (c) de recuit thermique, pendant laquelle les nanofils semiconducteurs 5 sont guidés ou orientés latéralement le long d'un moyen de guidage et selon un chemin prédéfini à l'avance.

L'étape de croissance latérale guidée des nanofils semiconducteurs 5 peut être réalisée selon trois méthodes ou alternatives possibles.

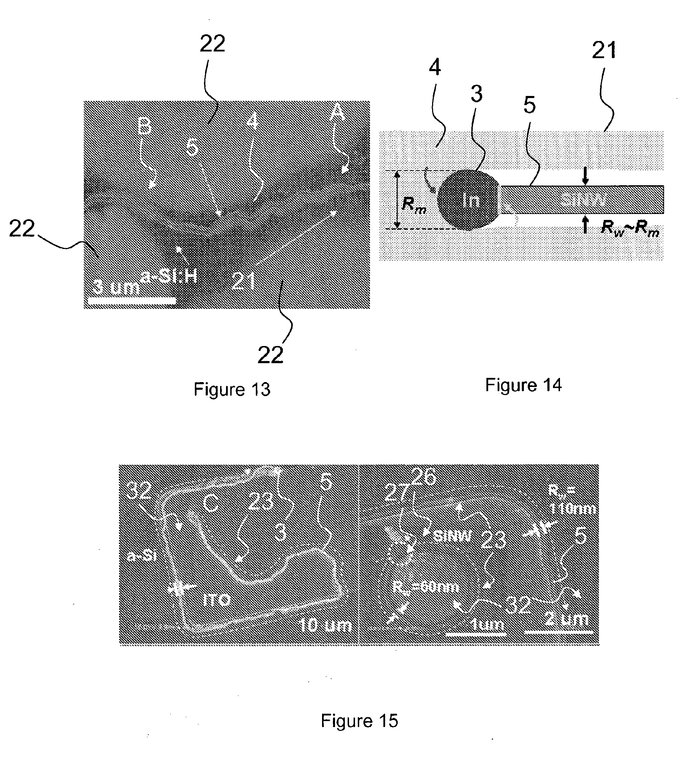

Dans l'exemple des figures 13 à 19, la couche mince 4 de matériaux semiconducteur est une couche de silicium amorphe hydrogéné (a-Si :H), la couche d'oxyde métallique 2 est une couche d'ITO, et les nanofils semiconducteurs 5 sont des nanofils de silicium cristallin (SiNW).

Une première méthode possible, illustrée sur les figures 13 et 14, consiste à définir ou tracer un canal de matériau semiconducteur 21 formant le moyen de guidage, qui est le seul précurseur d'alimentation, pour guider la croissance du nanofil semiconducteurs 5. Dans l'exemple des figures 13 et 14, le canal de matériau semiconducteur 21 est un canal de silicium amorphe hydrogéné, obtenu par gravure.

La figure 13 représente une photographie par MEB d'un nanofil de silicium cristallin 5 obtenu par cette première méthode de croissance latérale guidée.

La figure 14 représente schématiquement le principe de cette première méthode de croissance latérale guidée.

Cette opération de formation d'un canal de silicium amorphe hydrogéné 21 est réalisée entre l'étape (b) de dépôt assisté par plasma et l'étape (c) de recuit thermique. Elle consiste en une opération de gravure.

Sur la figure 13, un canal de silicium amorphe hydrogéné 21 étroit (dans le contraste noir) d'environ 12 $\mu$m de longueur a été défini entre trois régions vides 22 (dans le contraste blanc).

Un nanofil de silicium cristallin 5 s'est développé dans ce canal de silicium amorphe hydrogéné 21 de droite à gauche sur la figure, lors de l'étape (c) de recuit. Le nanofil de silicium cristallin 5 a suivi le chemin imposé par le silicium amorphe hydrogéné. Le diamètre $R_w$ du nanofil de silicium cristallin 5 est légèrement plus petit que le diamètre $R_m$ de la nanogoutte d'indium 3.

De manière préférée, le diamètre du canal de silicium amorphe hydrogéné 21 est sensiblement égale à celui de la nanogoutte d'indium 3 afin d'imposer une contrainte efficace sur le déplacement latéral du nanofil de silicium cristallin 5.

La taille et la morphologie du nanofil de silicium cristallin 5 sont influencées par la taille du canal de silicium amorphe hydrogéné 21. Dans la région A présentant une taille de canal de silicium amorphe hydrogéné 21 plus large, le nanofil de silicium cristallin 5 est large et ondulé. Dans la région B, le canal de silicium amorphe hydrogéné 21 est plus étroit, conduisant à une partie de nanofil de silicium cristallin 5 plus mince et plus droite.

Comme le canal de silicium amorphe hydrogéné 21 devient plus étroit de la région A vers la région B, la taille effective du canal ($R_{ch}$) devient plus petite que la taille de la nanogoutte d'indium 3.

Dans la région B, le nanofil de silicium cristallin 5 traîne derrière la nanogoutte d'indium 3 et tir sur ce dernier, conduisant à son étirement et à sa déformation (réduction du diamètre Rm).

La méthode consistant à définir ou tracer un canal de silicium amorphe hydrogéné 21 fournit un moyen de contrôle efficace et reproductible pour contrôler non seulement la direction de croissance du nanofil 5 mais également la morphologie et l'état de contrainte interne du nanofil 5.

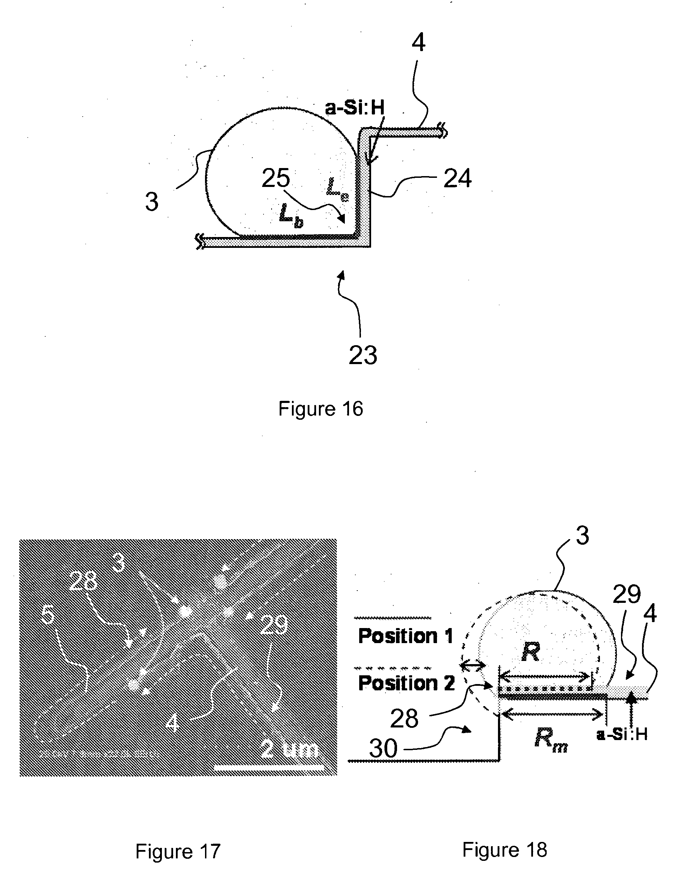

Il existe également une deuxième méthode possible de croissance latérale guidée des nanofils semiconducteurs 5, comme illustrée sur les figures 15 et 16.

La figure 15 représente deux photographies par MEB de nanofils de silicium cristallin 5 obtenus par cette deuxième méthode de croissance latérale guidée.

La figure 16 représente schématiquement le principe de cette deuxième méthode de croissance latérale guidée.

Cette deuxième méthode comprend une opération de formation d'une marche 23 sur le substrat 1. Cette opération de formation d'une marche 23 sur le substrat 1 est réalisée avant l'étape (a), pendant le dépôt de la couche d'oxyde métallique 2. Cette étape de dépôt d'une couche d'oxyde métallique 2 permet de former, sur le substrat 1, un ou plusieurs plots ou substrats d'oxyde métallique 32, d'ITO 32 par exemple. La forme du substrat d'ITO 32 peut être contôlée. Il se forme une marche 23 à la périphérie du substrat d'ITO 32.

La marche 23 est ensuite recouverte de la couche mince 4 de matériaux semiconducteur lors de l'étape (b) de dépôt assisté par plasma, tout en conservant sa forme générale de marche.

Cette marche 23 comprend une paroi latérale 24 recouverte d'une couche 4 de matériaux semiconducteurs tels du silicium amorphe hydrogéné et s'étend latéralement sur la couche d'oxyde métallique 2 selon un chemin prédéfini, formant un moyen de guidage. La paroi latérale 24 est préférentiellement perpendiculaire à la surface du substrat 1. Elle peut être égalent inclinée et non perpendiculaire à la surface du substrat 1. La paroi latérale 24 forme un coin 25 avec la surface horizontale du substrat 1.

Cette marche 23 permet de limiter le mouvement de la nanogoutte d'indium 3 pour la guider suivant le chemin de croissance prédéfini.

Comme illustré sur la photographie gauche de la figure 15, la croissance du nanofil de silicium cristallin 5 commence dans une région libre C, sans marche 23, et sur un substrat d'ITO 32 modelé (de 100 nanomètre d'épaisseur, par exemple), présentant des marches 23 préformées.

Quand le nanofil de silicium cristallin 5 atteint le coin 25 de la marche 23, il est piégé et se développe le long de la paroi latérale 24.

Quand le catalyseur est dans un coin 25, une interface supplémentaire d'absorption est formée sur la paroi latérale 24 verticale de la marche 23 et piège la nanogoutte d'indium 3 pour se déplacer le long du coin 25 et produire un nanofil de silicium cristallin 5 bien aligné.

Un guidage plus précis des nanofils de silicium cristallin 5 a été réalisé avec de plus petites nanogouttes d'indium 3 (diamètre compris entre 60 nm et 110 nm). Le nanofil de silicium cristallin 5 est plus étroitement lié à la marche 23.

Pour les nanogouttes 3 qui sont assez grosses pour enjamber le coin 25 de la marche 23, c'est-à-dire avoir deux points de contact dont un avec la paroi latérale 24 verticale et un autre avec la surface horizontale du substrat 1, sans contact avec le coin 23, il se forme simultanément deux nanofils de silicium cristallin 5 sensiblement parallèles le long de la marche 23.

Une paire de nanofils de silicium cristallin 5 avec des diamètres semblables est produite avec une seule nanogoutte 3. Un essai a été réalisé avec une nanogoutte de 2 $\mu$m de diamètre.

Cette paire de nanofils de silicium cristallin 5 est obtenue à partir de deux centres de nucléation indépendants qui coexistent sur la nanogoutte 3 mais qui sont séparés par le coin 25.

Avec cette deuxième méthode de croissance latérale guidée de nanofils de silicium cristallin 5, il est possible d'obtenir des formes de nanofils plus compliquées telle qu'une structure de nano anneau de silicium 26.

L'accessibilité électrique à cette structure de nano anneau 26 est fournie par les extrémités de la structure d'anneau 26, qui sont isolées par un espace isolé étroit 27.

De façon alternative, le procédé de fabrication de nanofils 5 comprend, entre l'étape (a) et l'étape (b) une étape de dépôt d'une couche de matériau diélectrique 33, suivie d'une étape de gravure de la couche de matériau diélectrique 33 pour former la marche 23 dans la couche de matériau diélectrique 33. Ce matériau diélectrique 33 est préférentiellement du nitrure de silicium.

La couche de matériau diélectrique 33 et la couche d'oxyde métallique 2 sont ensuite recouvertes d'une couche mince 4 d'un matériau semiconducteur lors de l'étape (b).

Il existe également une troisième méthode de croissance latérale guidée de nanofils de silicium cristallin 5, comme illustrée sur les figures 17 et 18.

La figure 17 représente une photographie par MEB de nanofils de silicium cristallin 5 obtenus par cette troisième méthode de croissance latérale guidée.

La figure 18 représente schématiquement le principe de cette troisième méthode de croissance latérale guidée.

La troisième méthode de croissance latérale guidée de nanofils de silicium cristallin 5 comprend, entre l'étape (b) de dépôt d'une couche mince 4 d'un matériau semiconducteur et l'étape (c) de recuit thermique, une opération (b') de formation de bordures ou d'arêtes 28 sur la couche mince 4 de matériau semiconducteur.

Dans les exemples des figures 17 et 18, la couche mince 4 de matériau semiconducteur est une couche mince de silicium amorphe hydrogéné.

Dans l'exemple de la figure 17, des tranches 29 de 200 nm de largeur ont été gravées au moyen d'un faisceau d'ions Ga$^+$ focalisé (FIB) sur une couche de silicium amorphe hydrogéné 4 ayant une épaisseur de 120 nm. La couche de silicium amorphe hydrogéné 4 avait été déposée sur un substrat d'ITO/Cg après traitement au plasma d'hydrogène.

Ces tranches 29 comprennent des bordures ou arêtes 28 disposés de chaque côté de ces dernières. Les tranches 29 sont gravées en suivant un chemin prédéfini et forment un moyen de guidage des nanofils 5.

Après l'étape (c) de recuit thermique, les nanogouttes métalliques 3 positionnées sur les bordures des tranches 29 deviennent actives et se déplacent le long des bordures 28 gravées dans le silicium amorphe hydrogéné, produisant des nanofils de silicium cristallin 5 bien alignés des deux côtés des tranches 29 gravées.

Les nanofils de silicium cristallin 5 obtenus avec cette troisième méthode sont plus droits ou rectilignes que ceux obtenus avec les première et deuxième méthodes, impliquant que $\eta \approx 1$.

Ceci résulte d'un mécanisme d'auto ajustement unique qui est seulement possible pour les nanofils de silicium cristallin 5 croissants le long d'une bordure 28 gravée dans le silicium amorphe hydrogéné.

Comme illustré sur la figure 18, lorsque la nanogoutte métallique 3 est poussée par le nanofil de silicium cristallin 5 par derrière, il est possible que la nanogoutte métallique 3 s'ajuste en s'inclinant vers le côté vide 30 (comme représenté par la transition de la position 1 vers la position 2 sur la figure 18).

De cette façon, la largeur efficace d'absorption au niveau de la bordure 28 de la tranche 29 de silicium peut être ajustée (et réduit à R < R$_m$) pour garder la condition d'équilibre de croissance de $\eta \approx 1$.

En revanche, lorsque la nanogoutte métallique 3 s'éloigne de la bordure 28, il se forme un nanofil de silicium cristallin 5 fortement recourbé.

Pour cette troisième méthode de croissance guidée, il est préférable d'avoir $\eta > 1$, de façon à forcer le nanofil de silicium cristallin 5 à se développer exactement le long de la bordure 28, au lieu de s'en éloigner et de se recourber.

En comparant les trois modes de croissance guidée, on remarque qu'il est plus simple de définir une bordure que de définir un canal de silicium.

Le troisième mode de croissance guidée est un procédé plus rentable et plus prometteur que le premier mode pour guider la croissance de nanofils de silicium cristallin 5 selon un chemin désiré.

Cependant, le premier mode de croissance guidée basé sur la formation d'un canal de silicium amorphe est plus efficace pour contrôler l'état de contrainte dans le nanofil de silicium cristallin 5, ce qui présente beaucoup d'importance pour la conception et la fabrication de dispositifs nanoélectroniques de haute performance.

En outre, ce premier mode de croissance peut être réalisé non seulement sur une surface plane, mais également sur la surface de n'importe quel objet à 3 dimensions, rendant la conception et la fabrication de réseaux fonctionnels de nanofils de silicium cristallin 5 à trois dimensions possible. Ceci permet des applications dans les circuits intégrés 3D et les systèmes nano-électro-mécaniques.

L'invention concerne également un procédé de fabrication d'un dispositif électronique, tel un transistor.

Ce procédé de fabrication comprend une étape (d) de formation d'une couche d'oxyde métallique 2 sur un substrat 1, de façon à définir une région d'initiation de la croissance de nanofils semiconducteurs 34.

Il comprend également une étape (e) de formation d'un ou plusieurs moyens de guidage pour la croissance de nanofils semiconducteurs 5. Chaque moyen de guidage relie la région d'initiation de la croissance de nanofils semiconducteurs 34 à une région de fin de croissance des nanofils semiconducteurs 35 de façon à définir un chemin fonctionnel.

Le procédé de fabrication comprend une étape (f) de fabrication d'un ou plusieurs nanofils semiconducteurs 5 selon les étapes (a), (b) et (c) de façon à réaliser une croissance guidée des nanofils semiconducteurs 5 le long des moyens de guidage respectifs. Lors de l'étape (c), chaque nanofil semiconducteur 5 initie ou commence sa croissance au niveau de la région d'initiation de la croissance de nanofils semiconducteurs 34, et la continue jusqu'à la région de fin de croissance des nanofils semiconducteurs 35.

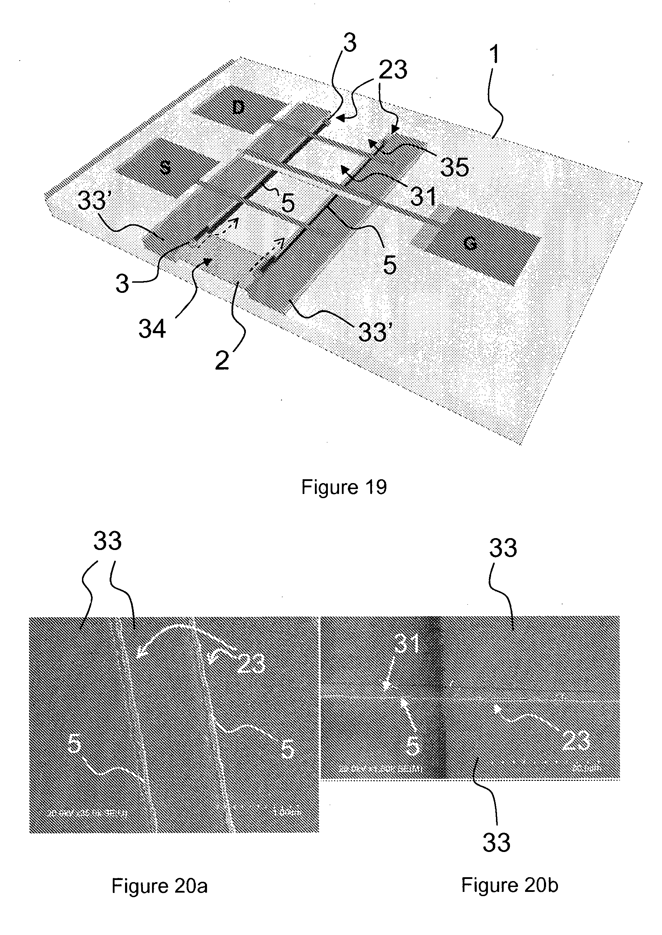

La figure 19 représente schématiquement un transistor TFT/FET obtenu avec ce procédé de l'invention.

Ce transistor comprend une source S, un drain D et une porte G supportés par un substrat 1.

Pour l'implémentation de nanofils de silicium cristallin 5 dans le transistor, il a été nécessaire de définir la position initiale pour initier le déclenchement de la croissance des nanofils 5, de contrôler la morphologie et le déploiement des nanofils 5 directement dans le circuit fonctionnel selon un chemin désiré, et d'isoler électroniquement les nanofils 5. Cette méthode est détaillée ci-dessous.

Tout d'abord, une région recouverte d'ITO a été définie comme région d'initiation de la croissance de nanofils semiconducteurs 34 ou région de départ de la croissance des nanofils 5 (étape (d)). Cette région recouverte d'ITO forme un plot d'ITO. L'ITO ne recouvre pas tout le substrat 1.

Ensuite, l'étape (e) est appliquée. Le substrat 1 a été recouvert d'une couche de matériau diélectrique 33 tel du nitrure de silicium. Cette couche de matériau diélectrique 33 peut avoir une épaisseur comprise entre 50 nm et 500 nm, par exemple. Le matériau diélectrique pour être du SiO$_2$, du HfO$_2$ ou un matériau ayant une constante diélectrique élevée.

L'étape de dépôt suivie d'une couche de matériau diélectrique 33 est suivie d'une étape de gravure de cette couche de matériau diélectrique 33 pour former une marche 23 dans la couche de matériau diélectrique 33.

Sur la figure 19, des fenêtres 31 ont été ouvertes dans la couche de matériau diélectrique 33 par gravure ionique, par exemple. Une des fenêtres 31 est ouverte sur la région d'ITO qui est définie comme la région active pour l'initialisation de la croissance des nanofils par un mécanisme de croissance solide-liquide-solide plan (IPSLS).

Durant cette gravure, des tranches ou canaux de matériau diélectrique 33' comprenant des marches 23 ont été formées. Ces marches 23 servent à guider la croissance des nanofils semiconducteurs 5. Une partie du plot d'ITO et une partie de la tranche de matériau diélectrique 33' sont en contact. Une partie de la tranche de matériau diélectrique 33' peut recouvrir partiellement le plot d'ITO.

Ensuite, l'étape (f) est appliquée. La couche d'ITO 2 est exposée à un plasma d'hydrogène durant l'étape (a) pour former des nanogouttes métalliques 3 à la surface de la couche d'oxyde métallique 2.

Puis une étape (b) de dépôt assisté par plasma basse température d'une couche mince 4 d'un matériau semiconducteur a été réalisée.

Dans le cas de la figure 19, après cette étape (b), une couche de silicium amorphe hydrogéné (non représentée) recouvre la couche d'ITO 2, la tranche de matériau diélectrique 33', et le substrat 1.

Ensuite, lors de l'étape (c) de recuit, les deux nanofils 5 de silicium commencent à se développer et s'étendent depuis la région d'initiation de la croissance de nanofils semiconducteurs 34 (région d'ITO exposée), jusqu'à la région de fin de croissance des nanofils semiconducteurs 35.

La marche 23 de chaque tranche de matériau diélectrique 33' piège le mouvement d'une nanogoutte métallique 3 et l'a guide selon un chemin fonctionnel prédéfini par la forme de la marche 23.

Dans l'exemple de la figure 19, ce chemin est rectiligne.

Pendant ce processus de croissance guidée, l'aspect rectiligne et la courbure du nanofil 5 ont été contrôlés. Le nombre de canaux de nanofil de silicium cristallin 5 peut être également contrôlé avec précision.

Le matériau semiconducteur (a-Si :H) résiduel peut être enlevé par gravure au plasma d'hydrogène à basse température (< 100°C), ce qui préserve la cristallinité du nanofil de silicium cristallin 5.

Dans cet exemple, on a obtenu par le procédé de l'invention un transistor comprenant deux nanofils de silicium cristallin 5 rectilignes et sensiblement parallèles, formant deux canaux de transistor complètement isolés électriquement.

La source S, le drain D et la porte G sont ensuite ajoutés sur le substrat 1. Les deux nanofils de silicium cristallin 5 forment une liaison semiconductrice entre la source 16, le drain 17 et la grille 18 du transistor.

Les tranches de matériau diélectrique 33' ont pour fonction de guider la croissance des nanofils 5 et également de les isoler électriquement du reste du dispositif électronique.

Les figures 20a et 20b représentent chacune une photographie par MEB de nanofils 5 d'un dispositif électronique.

La figure 20a représente un dispositif électronique comprenant deux marches 23 gravées dans une couche de nitrure de silicium 33. La couche de nitrure de silicium 33 a ensuite été recouverte d'une couche de silicium amorphe. Deux nanofils de silicium cristallin 5 rectilignes se sont formés le long de ces marches 23 respectives. Après la croissance des nanofils de silicium cristallin 5, la couche de silicium amorphe a été retirée par gravure.

La figure 20b représente un dispositif électronique comprenant une marches 23 gravée dans une couche de nitrure de silicium 33. Une fenêtre 31 a été ouverte par gravure dans la couche de nitrure de silicium 33 pour former une marche 23. La couche de nitrure de silicium 33 a ensuite été recouverte d'une couche de silicium amorphe. Le nanofil de silicium cristallin 5 a grandi le long de cette marche 23 et la couche de silicium amorphe a été retirée par gravure.

Cet exemple avec le silicium est transposable pour d'autres matériaux comme le germanium, par exemple.

Le procédé de l'invention peut être également utilisé pour des dispositifs électroniques autres que les transistors, tels des capteurs biologiques ou mécaniques. Les nanofils peuvent servir de guide d'onde optique par exemple.

Ainsi, le procédé de l'invention basé sur la formation de marches 23 permet de contrôler de façon efficace la position, le chemin, la morphologie et le nombre de nanofils de silicium cristallin 5.

Plusieurs nanofils de silicium cristallin 5 peuvent être formés directement sur un substrat pour former une matrice fonctionnelle de nanofils de silicium cristallin 5, tout en ayant l'isolation spatiale et électrique requise pour former un dispositif électronique apte à fonctionner.

Le dopage des nanofils de silicium cristallin 5 peut être réalisé en contrôlant le profil de dopage de chaque nanofil de silicium cristallin 5 d'une matrice de nanofil de silicium cristallin 5.

## Revendications

**1.** Procédé de fabrication de nanofils semiconducteurs (5) sur un substrat (1), comprenant une couche d'oxyde métallique (2), lesdits nanofils semiconducteurs (5) s'étendant sur la surface dudit substrat (1), **caractérisé en ce que** ledit procédé comprend les étapes suivantes :

- (a) exposition de la couche d'oxyde métallique (2) à un plasma d'hydrogène (11) de puissance P pendant une durée t apte à produire une réduction de la couche (2) et à former des nanogouttes métalliques (3) de rayon ($R_m$) en surface de la couche d'oxyde métallique (2) ;
- (b) dépôt assisté par plasma basse température d'une couche mince (4) d'un matériau semiconducteur sur la couche d'oxyde métallique (2) comprenant les nanogouttes métalliques (3), ladite couche mince (4) ayant une épaisseur ($H_a$) apte à recouvrir les nanogouttes métalliques (3) ;
- (c) recuit thermique sous vide à une température T supérieure ou égale à la température de fusion des nanogouttes métalliques (3) afin d'activer une croissance latérale de nanofils semiconducteurs (5) par catalyse du matériau semiconducteur déposé en couche mince (4) à partir des nanogouttes métalliques (3), ladite croissance latérale des nanofils semiconducteurs (5) s'étendant sur la surface et étant guidée par la surface dudit substrat (1).

2. Procédé de fabrication de nanofils semiconducteurs (5) selon la revendication 1 **caractérisé en ce que** le matériau semiconducteur déposé en couche mince (4) est choisi parmi du Silicium (Si), du Germanium (Ge), du Carbone (C), ou un alliage de ces matériaux (SiGe, SiC, ou SiGeC), ledit matériau semiconducteur étant déposé sous forme amorphe, micro- ou poly-cristalline.

3. Procédé de fabrication de nanofils (5) de silicium selon la revendication 2 **caractérisé en ce que** le matériau de la couche (4) est du silicium amorphe hydrogéné (a-Si :H) d'épaisseur ($H_a$).

4. Procédé de fabrication de nanofils (5) de carbone selon la revendication 2 **caractérisé en ce que** le matériau de la couche (4) est du carbone amorphe hydrogéné (a-C :H) d'épaisseur ($H_a$).

5. Procédé de fabrication de nanofils (5) selon l'une des revendications 1 à 3 **caractérisé en ce que** l'oxyde métallique (2) est un oxyde d'indium (InO), d'étain ($SnO_2$), de zinc (ZnO), un alliage ITO (Indium Tin Oxide), ou un système multicouche ZnO/ITO ou ZnO / $SnO_2$.

6. Procédé de fabrication de nanofils (5) selon l'une des revendications 1 à 4 **caractérisé en ce que** le rayon ($R_m$) des nanogouttes métalliques (3) étant connu, la durée de dépôt de la couche semiconductrice (4) est fixée de manière à obtenir un rapport η prédéterminé entre l'épaisseur ($H_a$) de la couche (4) déposée et le rayon ($R_m$), ce rapport η étant apte à assurer la croissance latérale des nanofils (5).

7. Procédé de fabrication de nanofils (5) selon la revendication 5 **caractérisé en ce que** le rapport η est égal à 1 de manière à ce que la morphologie des nanofils (5) soit rectiligne sur une longueur comprise entre 10 fois le diamètre du nanofil (5) à plus de 100 fois le diamètre du nanofil (5).

8. Procédé de fabrication de nanofils (5) selon l'une des revendications 1 à 7, **caractérisé en ce qu'**il comprend en outre une étape de masquage local de la couche d'oxyde métallique (2) de manière à former des électrodes (14, 15) et **en ce que** la croissance d'un nanofil (5) est réalisée entre deux électrodes (14, 15).

9. Procédé de fabrication de nanofils (5) selon l'une quelconque des revendications 1 à 8, **caractérisé en ce qu'**il comprend une étape de formation d'un moyen de guidage, lors de l'étape (c) de recuit thermique, la croissance latérale des nanofils semiconducteurs (5) étant guidée le long dudit moyen de guidage, selon un chemin prédéfini.

10. Procédé de fabrication de nanofils (5) selon la revendication 9, **caractérisé en ce que** l'étape de formation d'un moyen de guidage consiste à former un canal de matériau semiconducteur (21), ledit canal formant ledit moyen de guidage.

11. Procédé de fabrication de nanofils (5) selon la revendication 9, **caractérisé en ce que** l'étape de formation d'un moyen de guidage consiste à former une marche (23) sur le substrat (1), ladite marche (23) comprenant une paroi latérale (24), et formant ledit moyen de guidage.

12. Procédé de fabrication de nanofils (5) selon la revendication 11, **caractérisé en ce qu'**il comprend, entre l'étape (a) et l'étape (b) une étape de dépôt d'une couché de matériau diélectrique (33), suivie d'une étape de gravure de ladite couche de matériau diélectrique (33) pour former ladite marche (23) dans ladite couche de matériau diélectrique (33).

13. Procédé de fabrication d'un dispositif électronique comprenant un substrat (1) selon l'une quelconque des revendications 1 à 12, **caractérisé en ce que** le procédé comprend les étapes suivantes :

- (d) former une couche d'oxyde métallique (2) sur ledit substrat (1), de façon à définir une région d'initiation de la croissance de nanofils semiconducteurs (34),
- (e) former un ou plusieurs moyens de guidage pour la croissance de nanofils semiconducteurs (5), chaque moyen de guidage reliant la région d'initiation de la croissance de nanofils semiconducteurs (34) à une région de fin de croissance des nanofils semiconducteurs (35) de façon à définir un chemin fonctionnel,
- (f) fabriquer un ou plusieurs nanofils semiconducteurs (5) selon les étapes (a), (b) et (c) de façon à réaliser une croissance guidée des nanofils semiconducteurs (5) le long des moyens de guidage respectifs, lors de l'étape (c), chaque nanofil semiconducteur (5) initiant sa croissance au niveau de la région d'initiation de la croissance de nanofils semiconducteurs (34), et la continuant jusqu'à la région de fin de croissance des nanofils semiconducteurs (35).

14. Procédé de fabrication d'un dispositif électronique selon la revendication 13, **caractérisé en ce que** lors de l'étape (e), une étape de dépôt d'une couche de matériau diélectrique (33) sur le substrat (1) et la couche d'oxyde métallique (2) est réalisée entre les étapes (a) et (b), cette étape de dépôt d'une couche de matériau diélectrique (33) étant suivie d'une étape de gravure de ladite couche de matériau diélectrique (33) pour former une marche (23) dans ladite couche de matériau diélectrique (33), ladite marche (23) formant le moyen de guidage pour la croissance de nanofils semiconducteurs (5).

15. Transistor nanométrique (20) à base d'un ou plusieurs nanofils semiconducteurs (5) obtenus par le procédé de l'une des revendications 1 à 14, un des nanofils (5) étant apte à former une liaison semiconductrice entre une source (16), un drain (17) et une grille (18) dudit transistor, ledit nanofil semiconducteur (5) s'étendant sur la surface du substrat (1).

## Claims

1. A method of fabricating semiconductor nanowires (5) on a substrate (1) inducting a metallic oxide layer (2), said semiconductor nanowires (5) extending on the surface of said substrate (1),
   the method being **characterized in that** it comprises the following steps:

   a) exposing the metallic oxide layer (2) to a hydrogen plasma (11) of power P for a duration t for reducing the layer (2) and for forming metallic nanodrops (3) of radius ($R_m$) on the surface of the metallic oxide layer (2);
   b) low temperature plasma-assisted deposition of a thin layer (4) of a semiconductor material on the metallic oxide layer (2) inducting the Metallic nanodrops (3), thin layer (4) having a thickness ($H_a$) for covering the metallic nanodrops (3); and
   c) thermal annealing under vacuum at a temperature T higher than or equal tao the melting temperature of the metallic nanodrops (3) so as to activate lateral growth of semiconductor nanowires (5) by catalysis of the semiconductor material deposited as a thin layer (4) from the metallic nanodrops (3), said lateral growth of semiconductor nanowires (5) extending on the surface and being guided by the surface of said substrate (1).

2. A method of fabricating semiconductor nanowires (5) according to claim 1, **characterized in that** the semiconductor material deposited as a thin layer (4) is selected from silicon (Si), germanium (Ge), carbon (C), or an alloy of these materials (SiGe, SiC, or SiGeC), said semiconductor material being deposited in amorphous, micro- or poly-crystalline form.

3. A method of fabricating silicon nanowires (5) according to claim 2, **characterized in that** the material of the layer (4) is hydrogenated amorphous silicon (a-Si:H) having a thickness ($H_a$).

4. A method of fabricating carbon nanowires (5) according to claim 2, **characterized in that** the material of the layer (4) is hydrogenated amorphous carbon (a-C:H) having a thickness (H.).

5. A method of fabricating nanowires (5) according to any one of claims 1 to 3, **characterized in that** the metallic oxide (2) is an oxide of indium (InO), of tin ($SnO_2$), of zinc (ZnO), of indium tin alloy (ITO), or a multilayer system of ZnO/ITO or $ZnO/SnO_2$.

6. A method of fabricating nanowires (5) according to any of claims 1 to 4, **characterized in that** the radius ($R_m$) of

the metallic nanodrops (3) is known and the duration of deposition of the semiconductor layer (4) is determined in in such a manner as to obtain a predetermined ratio $\eta$ the thickness ($H_a$) of the deposited layer (4) and the radius ($R_m$), the ratio $\eta$ being suitable for ensuring lateral growth of the nanowires (5).

7. A method of fabricating nanowires (5) according to claim 5, **characterized in that** the ratio $\eta$ is equal to 1 so the morphology of the nanowires (5) is rectilinear over a length lying in the range of ten the diameter of the nanowire (5) to more than 100 times the diameter of the nanowire (5).

8. A method of fabricating nanowires (5) according to any one of claims 1 to 7, **characterized in that** it further comprises a step of locally the metallic oxide layer (2) so as to form electrodes (14, 15), and **in that** the growth of a nanowire (5) is performed two electrodes (14, 15).

9. A method of fabricating nanowires (5) according to any one of claims 1 to 8, **characterized in that** it includes a step of forming guide means the thermal annealing step c), the lateral growth of the semiconductor nanowires (5) being guided along said guide means along a predefined path.

10. A method of fabricating nanowires (5) according to claim 9, **characterized in that** the step of forming guide means consists in forming a channel (21) of semiconductor material, said channel forming said guide means,

11. A method of fabricating nanowires (5) according to claim 9, **characterized in that** the step of forming guide means consists in forming a step (23) on the substrate (1), said step (23) having a lateral wall (24) and forming said guide means.

12. A method of fabricating nanowires (5) according to claim 11, **characterized in that** it includes, between and step b), a step of depositing a layer (33) of dielectric material, followed by a step of etching said layer of dielectric material (33) to form said step (23) in said layer of dielectric material (33).

13. A method of fabricating an electronic device including a substrate (1) according to any one of claims 1 to 12, the method being **characterized in that** it comprises the following steps:

d) forming a layer (2) of metallic oxide on said substrate (1) so as to define a region (34) for initiating growth of semiconductor nanowires;
e) forming one or more guide means for the growth of semiconductor nanowires (5), each guide means connecting the semiconductor nanowire growth initiation region (34) to a region (35) for ending semiconductor nanowire growth so as to define a functional path; and
f) fabricating one or more semiconductor nanowires (5) in application of steps a), b), and c) so as to implement guided growth of semiconductor nanowires (5) along respective guide means during step c), each semiconductor nanowire (5) initiating its growth in the semiconductor nanowire growth initiation region (34) and continuing its growth to the semiconductor nanowire growth end region (35).

14. A method of fabricating an electronic device according to claim 13, **characterized in that** during step e), between steps a) and b) a step is performed of depositing a layer (33) of dielectric material on the substrate (1) and the layer (2) of metallic oxide, this step of depositing a dielectric material layer (33) being followed by a step of etching said dielectric material (33) to form a step (23) in said dielectric material layer (33), said step (23) forming the guide means for the growth of semiconductor nanowires (5).

15. A nanometric transistor (20) based on one or more semiconductor nanowires (5) obtained by the method according to any one of claims 1 to 14, one of the nanowires (5) being suitable for forming a semiconductive connection between a source (16), a drain (17), and a gate (18) of said transistor, said semiconductor nanowire (5) extending on the surface of said substrate (1).

**Patentansprüche**

1. Verfahren zur Herstellung von Halbleiternanodrähten (5) auf einem Substrat (1), das eine Metalloxidschicht (2) umfasst, wobei die Halbleiternanodrähte (5) sich auf der Fläche des Substrats (1) erstrecken, **dadurch gekennzeichnet, dass** das Verfahren die folgenden Schritte umfasst:

- (a) Aussetzen der Metalloxidschicht (2) gegenüber einem Wasserstoffplasma (11) mit der Leistung P während einer Dauer t, die geeignet ist, eine Verminderung der Schicht (2) zu erzeugen und auf der Fläche der Metalloxidschicht (2) metallische Nanotropfen (3) mit dem Radius (Rm) zu bilden;

- (b) durch ein Niedertemperaturplasma unterstütztes Abscheiden einer dünnen Schicht (4) aus einem Halbleitermaterial auf der Metalloxidschicht (2), die die metallischen Nanotropfen (3) umfasst, wobei die dünne Schicht (4) eine Dicke ($H_a$) aufweist, die geeignet ist, die metallischen Nanotropfen (3) zu bedecken;

- (c) thermisches Vakuumglühen bei einer Temperatur T, die größer oder gleich der Schmelztemperatur der metallischen Nanotropfen (3) ist, um ein Seitenwachstum von Halbleiternanodrähten (5) durch Katalyse des als dünne Schicht (4) abgeschiedenen Halbleitermaterials ausgehend von den metallischen Nanotropfen (3) zu aktivieren, wobei sich das Seitenwachstum der Halbleiternanodrähte (5) auf der Fläche erstreckt und durch die Fläche des Substrats (1) geführt wird.

2. Verfahren zur Herstellung von Halbleiter-Nanodrähten (5) nach Anspruch 1, **dadurch gekennzeichnet, dass** das als dünne Schicht (4) abgeschiedene Halbleitermaterial unter Silizium (Si), Germanium (Ge), Kohlenstoff (C) oder einer Legierung aus diesen Materialien (SiGe, SiC oder SiGeC) ausgewählt wird, wobei das Halbleitermaterial in amorpher, mikrokristalliner oder polykristalliner Form abgeschieden wird.

3. Verfahren zur Herstellung von Siliziumnanodrähten (5) nach Anspruch 2, **dadurch gekennzeichnet, dass** das Material der Schicht (4) hydriertes amorphes Silizium (a-Si:H) mit einer Dicke ($H_a$) ist.

4. Verfahren zur Herstellung von Kohlenstoffnanodrähten (5) nach Anspruch 2, **dadurch gekennzeichnet, dass** das Material der Schicht (4) hydrierter amorpher Kohlenstoff (a-C:H) mit einer Dicke ($H_a$) ist.

5. Verfahren zur Herstellung von Nanodrähten (5) nach einem der Ansprüche 1 bis 3, **dadurch gekennzeichnet, dass** die Metalloxidschicht (2) ein Indium- (InO), Zinn- ($SnO_2$) oder Zinkoxid (ZnO), eine ITO-Legierung (Indiumzinnoxid) oder ein ZnO/ITO- oder $ZnO/SnO_2$-Mehrschichtsystem ist.

6. Verfahren zur Herstellung von Nanodrähten (5) nach einem der Ansprüche 1 bis 4, **dadurch gekennzeichnet, dass**, da der Radius ($R_m$) der metallischen Nanotropfen (3) bekannt ist, die Dauer der Abscheidung der Halbleiterschicht (4) derart festgelegt ist, dass ein vorbestimmtes Verhältnis η zwischen der Dicke ($H_a$) der abgeschiedenen Schicht (4) und dem Radius ($R_m$) erhalten wird, wobei dieses Verhältnis η geeignet ist, das Seitenwachstum der Nanodrähte (5) zu gewährleisten.

7. Verfahren zur Herstellung von Nanodrähten (5) nach Anspruch 5, **dadurch gekennzeichnet, dass** das Verhältnis η gleich 1 ist, derart, dass die Morphologie der Nanodrahte (5) über eine Länge geradlinig ist, die zwischen dem 10-fachen des Durchmessers des Nanodrahts (5) und mehr als dem 100-fachen des Durchmessers des Nanodrahts (5) enthalten ist.

8. Verfahren zur Herstellung von Nanodrähten (5) nach einem der Ansprüche 1 bis 7, **dadurch gekennzeichnet, dass** es ferner einen Schritt des lokalen Abdeckens der Metalloxidschicht (2) umfasst, derart, dass Elektroden (14, 15) gebildet werden und dass das Wachstum eines Nanodrahts (5) zwischen zwei Elektroden (14, 15) ausgeführt wird.

9. Verfahren zur Herstellung von Nanodrähten (5) nach einem der Ansprüche 1 bis 8, **dadurch gekennzeichnet, dass** es beim Schritt (c) des thermischen Glühens einen Schritt der Bildung eines Führungsmittels umfasst, wobei das Seitenwachstum der Halbleiternanodrähte (5) gemäß einem vordefinierten Weg entlang des Führungsmittels geführt wird.

10. Verfahren zur Herstellung von Nanodrähten (5) nach Anspruch 9, **dadurch gekennzeichnet, dass** der Schritt des Bildens eines Führungsmittels darin besteht, einen Kanal aus Halbleitermaterial (21) zu bilden, wobei der Kanal das Führungsmittel bildet.

11. Verfahren zur Herstellung von Nanodrahten (5) nach Anspruch 9, **dadurch gekennzeichnet, dass** der Schritt des Bildens eines Führungsmittels darin besteht, eine Führung (23) auf dem Substrat (1) zu bilden, wobei die Führung (23) eine Seitenwand (24) umfasst und das Führungsmittel bildet.

12. Verfahren zur Herstellung von Nanodrähten (5) nach Anspruch 11, **dadurch gekennzeichnet, dass** es zwischen dem Schritt (a) und dem Schritt (b) einen Schritt des Abscheidens Schicht aus dielektrischem Material (33), gefolgt von einem Schritt des Ätzens der Schicht aus dielektrischem Material (33) umfasst, um die Führung (23) in der Schicht aus dielektrischem Material (33) zu bilden.

13. Verfahren zur Herstellung einer elektronischen Vorrichtung, die ein Substrat (1) nach einem der Ansprüche 1 bis 12 umfasst, **dadurch gekennzeichnet, dass** das Verfahren die folgenden Schritte umfasst:

- (d) Bilden einer Metalloxidschicht (2) auf dem Substrat (1), derart, dass eine Region für die Initiierung des Wachstums von Halbleiternanodrähten (34) abgegrenzt wird;
- (e) Bilden von einem oder mehreren Führungsmitteln für das Wachstum von Halbleiternanodrähten (5), wobei jedes Führungsmittel die Region für die initiierung des Wachstums von Halbleiternanodrähten (34) mit einer Region für das Ende des Wachstums der Halbleiternanodrähte (35) verbindet, derart, dass ein Funktionsweg abgegrenzt wird,
- (f) Herstellen von einem oder mehreren Halbleiternanodrähten (5) nach den Schritten (a), (b) und (c), derart, dass ein geführtes Wachstum der Halbleiternanodrähte (5) entlang der jeweiligen Führungsmittel ausgeführt wird, wobei im Schritt (c) jeder Halbleiternanodraht (5) sein Wachstum im Bereich der Region zur initiierung des Wachstums von Halbleiternanodrähten (34) initiiert und es bis zur Region des Endes des Wachstums der Halbleiternanodrähte (35) fortsetzt.

14. Verfahren zur Herstellung einer elektronischen Vorrichtung nach Anspruch 13, **dadurch gekennzeichnet, dass** im Schritt (e) zwischen den Schritten (a) und (b) ein Schritt des Abscheidens einer Schicht aus dielektrischem Material (33) auf dem Substrat (1) und der Schicht aus Metalloxid (2) ausgeführt wird, wobei auf diesen Schritt des Abscheidens einer Schicht aus dielektrischem Material (33) ein Schritt des Ätzens der Schicht aus dielektrischem Material (33) folgt, um eine Führung (23) in der Schicht aus dielektrischem Material (33) zu bilden, wobei die Führung (23) das Führungsmittel für das Wachstum von Halbleiternanodrähten (5) bildet.

15. Nanotransistor (20) auf der Grundlage von einem oder mehreren Halbleiternanodrähten (5), die durch das Verfahren nach einem der Ansprüche 1 bis 14 erhalten werden, wobei einer der Nanodrähte (5) geeignet ist, eine Halbleiterverbindung zwischen einer Source (16), einem Drain (17) und einem Gate (18) des Transistors zu bilden, wobei der Halbleiternanodraht (5) sich auf der Fläche des Substrats (1) erstreckt.

Figure 1

Figure 2

Figure 3

Figure 4

Figure 5

Figure 6

Figure 7

Figure 8

Figure 9

D=650~800nm
L=26um

18

16

5

17

20

Figure 10

18

19

5

1

Figure 11

Figure 12

Figure 13

Figure 14

Figure 15

Figure 16

Figure 17

Figure 18

Figure 19

Figure 20a

Figure 20b

**EP 2 334 848 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2860780 D, D. Pribat
- FR 2888041 D, D. Pribat
- FR 2888041

**Littérature non-brevet citée dans la description**

- **P.J. ALET et al.** *J. of Mater. Chem,* 2008, vol. 18, 5187-5189
- **V. SCHMIDT et al.** *Small,* 2006, vol. 2 (1), 85-88